Europäisches Patentamt

European Patent Office

Office européen des brevets

(19)

(11) **EP 1 625 659 B1**

(12) **FASCICULE DE BREVET EUROPEEN**

(45) Date de publication et mention
de la délivrance du brevet:
**26.07.2006 Bulletin 2006/30**

(21) Numéro de dépôt: **04729809.6**

(22) Date de dépôt: **28.04.2004**

(51) Int Cl.:
*H03H 9/02* (2006.01)     *H03H 3/013* (2006.01)

(86) Numéro de dépôt international:
**PCT/CH2004/000258**

(87) Numéro de publication internationale:
**WO 2004/102796 (25.11.2004 Gazette 2004/48)**

(54) **RESONATEURS INTEGRES ET BASE DE TEMPS INCORPORANT DE TELS RESONATEURS**

INTEGRIERTE RESONATOREN UND ZEITBASIS MIT SOLCHEN RESONATOREN

INTEGRATED RESONATORS AND TIME BASE INCORPORATING SAID RESONATORS

(84) Etats contractants désignés:
**AT BE BG CH CY CZ DE DK EE ES FI FR GB GR
HU IE IT LI LU MC NL PL PT RO SE SI SK TR**

(30) Priorité: **15.05.2003 FR 0305833**

(43) Date de publication de la demande:
**15.02.2006 Bulletin 2006/07**

(73) Titulaire: **CSEM Centre Suisse d'Electronique et
de
Microtechnique S.A. - Recherche et
Développement
2007 Neuchâtel (CH)**

(72) Inventeur: **BOURGEOIS, Claude
CH-2014 Bôle (CH)**

(74) Mandataire: **GLN
Rue du Puits-Godet 8a
2000 Neuchâtel (CH)**

(56) Documents cités:
**WO-A-03/017482**

- **VEIS J: "Temperature compensation of silicon
resonant pressure sensor" SENSORS AND
ACTUATORS A, ELSEVIER SEQUOIA S.A.,
LAUSANNE, CH, vol. 57, no. 3, 1 décembre 1996
(1996-12-01), pages 179-182, XP004081077 ISSN:
0924-4247**
- **BOURGEOIS C ET AL: "Design of resonators for
the determination of the temperature coefficients
of elastic constants of monocrystalline silicon"
FREQUENCY CONTROL SYMPOSIUM, 1997.,
PROCEEDINGS OF THE 1997 IEEE
INTERNATIONAL ORLANDO, FL, USA 28-30 MAY
1997, NEW YORK, NY, USA,IEEE, US, 28 mai 1997
(1997-05-28), pages 791-799, XP010257368 ISBN:
0-7803-3728-X**
- **J J YAO, N C MACDONALD: "A micromachined,
single-crystal silicon, tunable resonator" J.
MICROMECH. MICROENG., vol. 5, no. 3, 28 mai
1997 (1997-05-28), - septembre 1995 (1995-09)
pages 257-264, XP002258605**

**Description**

La présente invention se rapporte aux résonateurs en général et concerne, plus particulièrement, les résonateurs intégrés en silicium monocristallin, permettant la réalisation d'une base de temps stable en température, ainsi qu'une base de temps réalisée avec de tels résonateurs.

Le quartz est certainement le matériau le plus utilisé pour la fabrication de résonateurs car c'est l'un des rares cristaux connus qui permette l'annulation, à température ambiante, du premier coefficient thermique de la fréquence par un choix approprié des angles de coupe des résonateurs. De plus, la compensation des dérives thermiques, dues aux coefficients d'ordres plus élevés, est également possible par une adaptation de la géométrie même de ces résonateurs. Enfin, le quartz est également piézoélectrique, ce qui permet une excitation directe des modes de vibration choisis. Bien que le quartz reste un matériau de choix pour la réalisation de structures résonantes, il existe, toutefois, une demande de plus en plus forte pour l'intégration de telles structures dans un substrat de silicium; matériau utilisé pour les circuits intégrés ainsi que pour un nombre croissant de structures de type "MEMS" (Micro-Electro-Mechanical Systems).

Un exemple de résonateur intégré dans un substrat de silicium monocristallin peut être trouvé dans la demande de brevet européen EP 079 59 53. Les coefficients thermiques de la fréquence d'un tel résonateur sont, respectivement, de l'ordre de - 30 ppm (parties par million ou $10^{-6}$) / °C pour le coefficient de premier ordre $\alpha$ et de -13 ppb (parties par milliard ou $10^{-9}$) / °C$^2$ pour le coefficient de deuxième ordre $\beta$. Pour les compenser, il est proposé d'utiliser un thermomètre, intégré dans le même substrat, agissant sur un circuit d'ajustement de fréquence. Non seulement, une telle méthode de compensation implique un étalonnage de l'ensemble du résonateur et de l'oscillateur après fabrication mais encore, sa précision dépend de celle du thermomètre intégré qui est loin d'être idéale, en particulier, si l'on considère les effets du vieillissement.

Aussi un but de la présente invention est la réalisation de résonateurs intégrés dans un substrat de silicium monocristallin et dont les dérives thermiques peuvent être compensées de manière simple et précise.

Un objet de l'invention est un ensemble de résonateurs, intégrés dans un substrat de silicium monocristallin et destinés à permettre la réalisation d'une base de temps stable en température, caractérisé en ce qu'il comprend au moins un premier et un deuxième résonateurs prévus pour osciller selon des modes de types différents et avec des dimensions telles qu'au moins le premier coefficient thermique de la différence de leur fréquence est égal ou proche de zéro.

Selon une autre caractéristique de l'invention, le deuxième coefficient thermique de la différence des fréquences est également rendu proche de zéro par une orientation donnée des résonateurs dans le substrat de silicium.

Grâce à ces caractéristiques, la compensation thermique est obtenue par la différence des fréquences de deux résonateurs oscillant sur des modes de types différents, cette différence pouvant être rendue indépendante de la température.

L'ensemble de résonateurs selon l'invention possède encore toutes ou certaines des caractéristiques énoncées ci-après:

- ledit premier résonateur est prévu pour osciller selon un mode d'allongement;
- ledit deuxième résonateur est prévu pour osciller selon un mode de cisaillement de surface;
- lesdits premier et second résonateurs ont, chacun, une structure symétrique constituée par un bras central reliant deux plaques rectangulaires, lesdits résonateurs pouvant être tenus au niveau de la partie médiane desdits bras centraux;
- lesdits résonateurs comportent des moyens d'excitation piézoélectrique;
- lesdits moyens d'excitation piézoélectrique comprennent une couche d'AIN déposée sur lesdits bras centraux et des électrodes permettant de contacter ladite couche d'AIN;
- le substrat de silicium est dopé et constitue l'une des électrodes desdits moyens d'excitation piézoélectrique.

D'autres objets, caractéristiques et avantages de la présente invention apparaîtront à la lecture de la description suivante faite à titre d'exemple non limitatif et en relation avec les dessins annexés dans lesquels:

- la figure 1 montre un ensemble de deux résonateurs selon l'invention réalisés dans une plaque de silicium monocristallin d'orientation {001};

- les figures 2.a et 2.b montrent les variations des premiers et deuxièmes coefficients thermiques, respectivement, des résonateurs de la figure 1 en fonction de l'orientation de ces derniers;

- la figure 3 représente les géométries des dépôts d'AIN et des électrodes sur le résonateur 3 de la figure 1;

- la figure 4 montre une vue en coupe du résonateur de la figure 3; et

- la figure 5 est un exemple de circuit permettant d'extraire la différence des fréquences des résonateurs de l'invention.

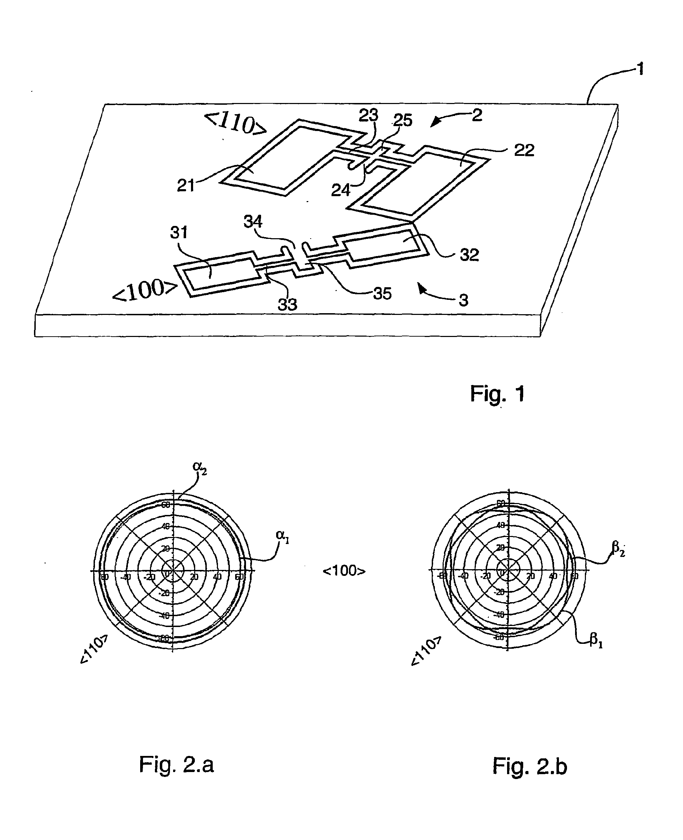

Les deux résonateurs 2 et 3 de la figure 1 oscillent selon des modes dits "modes de contour"; ce qui signifie qu'ils se présentent sous la forme de plaques minces vibrant dans leur plan et dont la fréquence est indépendante de l'épaisseur desdites plaques. Leur structure correspond à deux plaques rectangulaires 21, 22, 31, 32 reliées par un bras central 23, 33, lui-même connecté au substrat 1 de silicium monocristallin par l'intermédiaire d'un bras de fixation 24, 34. Une zone rectangulaire 25, 35, située dans le prolongement du et opposée au bras de fixation, a pour but de symétriser l'ensemble de chaque résonateur et, par suite, ses déformations en contrebalançant l'évanescence dans la zone d'encastrement et ce, dans le but d'atteindre des facteurs de qualité élevés. Dans l'exemple décrit, le résonateur 2 est prévu pour osciller selon un mode de Lamé; l'onde de cisaillement qui lui est associée se propageant selon les diagonales des carrés inscrits dans les plaques 21 et 22, et il est orienté selon la direction <110> du substrat, tandis que le résonateur 3, avec son axe longitudinal en ligne avec la direction <100> du substrat, est prévu pour osciller selon un mode d'allongement de son bras central 33.

Conformément à l'invention, la compensation thermique est obtenue par la différence des fréquences de deux résonateurs oscillant selon des modes différents. La fréquence du résonateur 2 peut s'exprimer sous la forme:

$$F_1 = F_{10}(1 + \alpha_1.\Delta T + \beta_1.\Delta T^2 + \gamma_1.\Delta T^3 + ...) \,,$$

où $F_{10}$ est la fréquence propre du résonateur 2, $\Delta T$ est la variation de température et $\alpha_1$, $\beta_1$, $\gamma_1$ sont les coefficients thermiques de la fréquence $F_1$ de premier, deuxième et troisième ordres, respectivement.

La fréquence du résonateur 3 peut, de même, s'exprimer sous la forme:

$$F_2 = F_{20}(1 + \alpha_2.\Delta T + \beta_2.\Delta T^2 + \gamma_2.\Delta T^3 + ...) \,,$$

où $F_{20}$ est la fréquence propre du résonateur 3, $\Delta T$ est la variation de température et $\alpha_2$, $\beta_2$, $\gamma_2$ sont les coefficients thermiques de la fréquence $F_2$ de premier, deuxième et troisième ordres, respectivement.

La différence des fréquences $F_{12}$ peut donc s'écrire:

$$F_{12} = F_1 - F_2 = (F_{10} - F_{20})(1 + \alpha.\Delta T + \beta.\Delta T^2 + \gamma\Delta T^3 + ...)$$

avec:

$$\alpha = \frac{F_{10}.\alpha1 - F_{20}.\alpha2}{F_{10} - F_{20}} \,,$$

$$\beta = \frac{F_{10}.\beta_1 - F_{20}.\beta_2}{F_{10} - F_{20}} \,,$$

et

$$\gamma = \frac{F_{10} \cdot \gamma_1 - F_{20} \cdot \gamma_2}{F_{10} - F_{20}}.$$

La compensation du premier coefficient thermique se fait alors en posant:

$$F_{10} \cdot \alpha_1 - F_{20} \cdot \alpha_2 = 0 \ \text{soit,} \ \frac{F_{10}}{F_{20}} = \frac{\alpha_2}{\alpha_1},$$

le deuxième coefficient thermique étant alors égal à:

$$\beta = \frac{\alpha_2 \beta_1 - \alpha_1 \beta_2}{\alpha_2 - \alpha_1}$$

L'équation ci-dessus montre que le contrôle de $\beta$ est d'autant meilleur que $\alpha_1$ et $\alpha_2$ sont différents l'un de l'autre. Afin d'optimiser le contrôle de l'annulation du premier coefficient thermique $\alpha$ de la différence de fréquence $F_{12}$, les modes de vibration des deux résonateurs 2 et 3 sont choisis de telle sorte que les coefficients thermiques du premier ordre qui leur sont associés soient aussi différents que possible l'un de l'autre. C'est ainsi que selon une variante avantageuse de l'invention, le mode de vibration du premier résonateur est un mode de cisaillement de surface, sous-tendu par un mode de Lamé, tandis que le mode de vibration du second est un mode d'allongement. La précision du premier coefficient thermique $\alpha$ dépend du rapport des fréquences des deux résonateurs, soit d'un rapport dimensionnel entre ces derniers et non de leurs dimensions absolues. Comme les deux résonateurs sont réalisés sur le même substrat, ce premier coefficient thermique est de fait peu sensible à des effets de sous-attaque ou à des erreurs de découpe.

L'expression du deuxième coefficient thermique $\beta$ de la différence de fréquence $F_{12}$ montre que celui-ci peut être annulé, ou fortement réduit, en choisissant un rapport de $\dfrac{\beta_1}{\beta_2}$ égal au, ou proche du, rapport $\dfrac{\alpha_1}{\alpha_2}$. Cette condition peut être réalisée par un choix judicieux des orientations des deux résonateurs. Les figures 2.a et 2.b montrent, pour les deux modes de vibration choisis, les variations des premiers et deuxièmes coefficients thermiques $\alpha 1$ et $\alpha_2$, $\beta_1$ et $\beta_2$, respectivement, en fonction des orientations des résonateurs. Si les coefficients thermiques du premier ordre varient peu avec l'orientation, il n'en est pas de même des coefficients du deuxième ordre et on peut voir que la condition précédemment indiquée peut être réalisée lorsque les orientations des résonateurs forment, l'une par rapport à l'autre, un angle d'environ 45°, les ondes de cisaillement et d'allongement se propageant, alors, selon la direction <100>.

Les structures planaires, avec des zones d'évanescence équilibrées, et les modes de vibration envisagés des résonateurs permettent d'obtenir des facteurs de qualité élevés; ce qui rend possible la réalisation de bases de temps (résonateurs et oscillateurs) à faible consommation. Par ailleurs, afin d'atténuer fortement le couplage avec les modes de vibration à plus basse fréquence, le résonateur 2 peut être réalisé en ayant des masses 21 et 22 sous la forme d'un empilage (au moins deux)de plaques carrées sans, toutefois, que cela modifie la fréquence du mode de Lamé. Il s'agit là d'une propriété des modes de Lamé qui peut être mise à profit pour augmenter l'efficacité de l'ensemble résonateur et oscillateur.

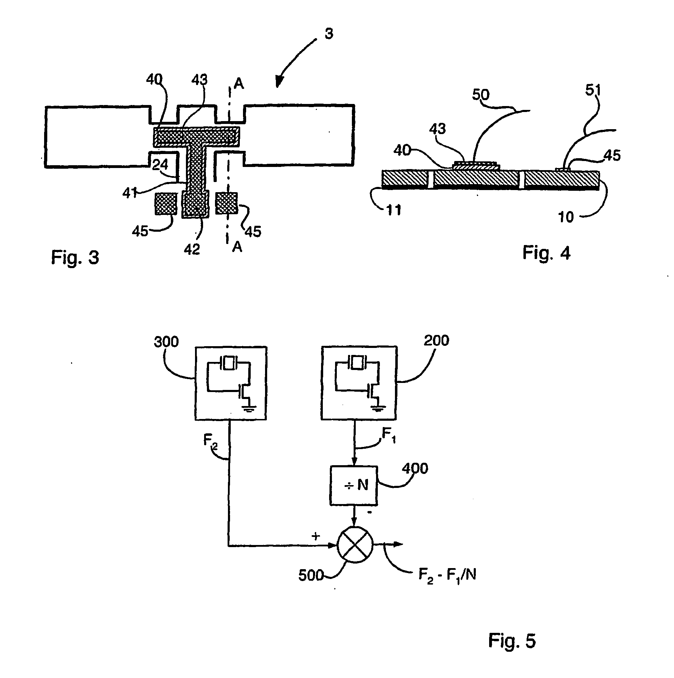

De manière connue, l'excitation des résonateurs peut être faite par un couplage de type électrostatique ou de type piézoélectrique. Selon une variante avantageuse de l'invention, ceux-ci sont excités par effet piézoélectrique, par exemple, par l'intermédiaire d'une couche de nitrure d'aluminium (AlN). Comme indiqué sur la figure 3 représentant, par exemple, le résonateur 3, le couplage piézoélectrique est réalisé par un dépôt d'AlN 40 dans la région centrale du bras, à l'endroit où les déformations d'allongement sont les plus importantes. Cette zone rectangulaire d'environ 225 $\mu$m x 950 $\mu$m se prolonge le long du bras de fixation 24 par l'intermédiaire d'une bande mince 41 jusqu'à une zone de connexion 42, ayant à peu près 120 $\mu$m de côté et sur laquelle peut être soudé un fil de connexion. Comme représenté sur la vue en coupe, selon l'axe A-A de la figure 3, de la figure 4, la couche 40 de nitrure d'aluminium est recouverte d'une couche d'aluminium 43, couche qui est également déposée directement sur le substrat pour former les plots 45 de connexion à ce dernier. Dans le cas où le silicium formant substrat ne serait pas dopé, il y aurait lieu de prévoir une seconde électrode entre le substrat et la couche de nitrure d'aluminium. Cette seconde électrode est, de préférence, réalisée en platine; matériau se prêtant particulièrement bien à la croissance du nitrure d'aluminium. La figure 4 montre également le fait que le substrat est, en fait, une plaque de silicium 10 dont la face inférieure est en oxyde de silicium. De telles plaques, appelées "SOI" ce qui signifie silicium sur isolant, ont déjà l'épaisseur voulue. Comme cela a été mentionné précédemment, l'épaisseur des résonateurs est un paramètre relativement libre qui est déterminé en fonction de l'application. Ainsi une épaisseur élevée permet d'avoir une résistance aux chocs élevée et un effet réduit de couplage avec d'autres modes de vibration hors du plan alors qu'une faible épaisseur permet un fort couplage piézoélectrique et donc, une faible consommation de l'oscillateur. A titre d'exemple non limitatif, les résonateurs ont une épaisseur d'environ 50 μm.

Les étapes de fabrication des résonateurs sont données ci-après à titre d'exemple non limitatif:

- Dépôt, par pulvérisation, d'une couche d'environ 100 nm de platine (Pt) sur la face supérieure (A) du substrat de silicium;
- Structuration de la couche de platine, par photolithographie et gravure plasma, pour la réalisation des premières électrodes;
- Dépôt, par pulvérisation, d'une couche de nitrure d'aluminium (quelques μm);
- Dépôt, par pulvérisation, d'une couche (environ 100 nm) d'aluminium et usinage sélectif de cette couche pour la réalisation des deuxièmes électrodes;
- Gravure de la couche d'AIN pour définir les zones d'excitation piézoélectrique;
- Attaque rapide par plasma ("Deep Reactive Ion Etching") de la face A pour définir la géométrie des résonateurs;
- Eventuellement, découpe des résonateurs par sciage; et
- Mise sous vide et connexion des résonateurs à leur circuit associé.

A titre indicatif, les paramètres des résonateurs sont indiqués ci-après.
Pour le résonateur 2,

- dimensions des plaques: 2X1 mm;
- longueur du bras central: 1 mm;
- fréquence: ≈ 4 MHz.

Pour le résonateur 3,

- longueur hors tout: 2,5mm;
- longueur du bras central: 1,2mm;
- fréquence: ≈ 1 MHz.

Un exemple de circuit permettant de délivrer une fréquence stable en température à partir des résonateurs décrits ci-dessus est schématiquement représenté à la figure 5. Le bloc 200 représente l'ensemble du résonateur 2 et de l'oscillateur qui lui est associé et le bloc 300 représente l'ensemble du résonateur 3 et de l'oscillateur qui lui est associé. Le bloc 200 délivre un signal à la fréquence $F_1$ et le bloc 300 délivre un signal à la fréquence $F_2$, la fréquence $F_1$ étant, selon l'exemple décrit où les les deux résonateurs ont des dimensions semblables, plus élevée (d'environ 4 fois) que la fréquence $F_2$. La fréquence $F_1$ est donc divisée par un circuit diviseur de fréquence 400, lequel fournit un signal à la fréquence $\dfrac{F_1}{N}$, où N est un nombre entier (égal à 4 dans l'exemple considéré), qui représente le rapport de division du circuit diviseur 400. Les signaux issus du bloc 300 et du circuit diviseur 400 sont appliqués au circuit 500 qui fournit la différence $F_2 - \dfrac{F_1}{N}$. Comme indiqué précédemment, cette différence de fréquence est indépendante de la variation de température et peut donc servir à réaliser une base de temps intégrée, stable et précise et pouvant être utilisée dans beaucoup d'applications, en particulier, des applications portables.

Bien que la présente invention ait été décrite en relation avec des exemples de réalisation particuliers, on comprendra qu'elle est susceptible de modifications ou variantes sans pour autant sortir de son domaine. Ainsi, si le silicium a été retenu pour la présente description, les résonateurs de l'invention pourraient être réalisés dans d'autres monocristaux. De même, les modes de vibration choisis ne doivent être considérés qu'à titre d'exemples non limitatifs.

**Revendications**

1. Ensemble de résonateurs intégrés dans un monocristal (1) et destinés à permettre la réalisation d'une base de temps stable en température, **caractérisé en ce qu'**il comprend au moins un premier (2) et un deuxième (3) résonateurs prévus pour osciller selon des modes de types différents et avec des dimensions telles qu'au moins le premier coefficient thermique de la différence de leur fréquence $\alpha$ est égal ou proche de zéro.

2. Ensemble de résonateurs selon la revendication 1, **caractérisé en ce** ledit monocristal est du silicium.

3. Ensemble de résonateurs selon la revendication 1 ou la revendication 2, **caractérisé en ce que** lesdits premier et deuxième résonateurs sont orientés selon un angle tel que le deuxième coefficient thermique de ladite différence de fréquence $\beta$ est égal ou proche de zéro.

4. Ensemble de résonateurs selon l'une des revendications 1 à 3, **caractérisé en ce que** ledit premier résonateur (2) est prévu pour osciller selon un mode d'allongement.

5. Ensemble de résonateurs selon l'une des revendications 1 à 4, **caractérisé en ce que** ledit deuxième résonateur (3) est prévu pour osciller selon un mode de Lamé.

6. Ensemble de résonateurs selon l'une quelconque des revendications précédentes, **caractérisé en ce que** lesdits premier et second résonateurs ont, chacun, une structure symétrique constituée par un bras central (23, 33) reliant deux plaques rectangulaires (21, 22 et 31, 32), lesdits résonateurs pouvant être tenus au niveau de la partie médiane (24, 34) desdits bras centraux.

7. Ensemble de résonateurs selon l'une quelconque des revendications précédentes, **caractérisé en ce que** lesdits résonateurs comportent des moyens d'excitation piézoélectrique.

8. Ensemble de résonateurs selon la revendication 7,
**caractérisé en ce** lesdits moyens d'excitation piézoélectrique comprennent une couche d'AIN (40) déposée sur lesdits bras centraux et des électrodes (43, 45) permettant de contacter ladite couche d'AIN, d'une part, et le substrat de silicium, d'autre part.

9. Ensemble de résonateurs selon la revendication 8, **caractérisé en ce que** le substrat de silicium est dopé et constitue l'une des électrodes desdits moyens d'excitation piézoélectrique.

10. Base de temps compensée en température, **caractérisée en ce qu'**elle comprend un ensemble de résonateurs selon l'une quelconque des revendications précédentes, des moyens pour exciter et entretenir leur oscillation (200, 300) et des moyens (400, 500) pour engendrer un signal stable en température représentatif de la différence des fréquences d'oscillation desdits résonateurs.

11. Base de temps selon la revendication 10, **caractérisée en ce qu'**un des deux résonateurs a une fréquence d'oscillation beaucoup plus grande que celle de l'autre et lesdits moyens pour engendrer un signal stable en température comportent, en outre, un circuit diviseur de fréquence (400) pour réduire la fréquence la plus élevée avant d'effectuer ladite différence des fréquences d'oscillation.

**Claims**

1. A set of resonators that are integrated in a single crystal (1) and intended to allow a temperature-stable time base to be produced, **characterized in that** it comprises at least first (2) and second (3) resonators designed to oscillate in modes of different type and with dimensions such that at least the first thermal coefficient $\alpha$ of their frequency difference is equal or close to zero.

2. The set of resonators as claimed in claim 1, **characterized in that** said single crystal is a silicon single crystal.

3. The set of resonators as claimed in claim 1 or claim 2, **characterized in that** said first and second resonators are oriented at an angle such that the second thermal coefficient $\beta$ of said frequency difference is equal or close to zero.

4. The set of resonators as claimed in one of claims 1 to 3, **characterized in that** said first resonator (2) is designed to oscillate in an elongation mode.

5. The set of resonators as claimed in one of claims 1 to 4, **characterized in that** said second resonator (3) is designed to oscillate in a Lamé mode.

6. The set of resonators as claimed in any one of the preceding claims, **characterized in that** said first and second resonators each have a symmetrical structure formed by a central arm (23, 33) joining two rectangular plates (21, 22 and 31, 32), said resonators being able to be held in the middle part (24, 34) of said central arms.

7. The set of resonators as claimed in any one of the preceding claims, **characterized in that** said resonators include piezoelectric excitation means.

8. The set of resonators as claimed in claim 7, **characterized in that** said piezoelectric excitation means comprise an AIN layer (40) deposited on said central arms and electrodes (43, 45) for contacting, on the one hand, said AIN layer and, on the other hand, the silicon substrate.

9. The set of resonators as claimed in claim 8, **characterized in that** the silicon substrate is doped and constitutes one of the electrodes for said piezoelectric excitation means.

10. A temperature-compensated time base, **characterized in that** it comprises a set of resonators as claimed in any one of the preceding claims, means (200, 300) for exciting and sustaining their oscillations and means (400, 500) for generating a temperature-stable signal representative of the difference in oscillation frequencies of said resonators.

11. The time base as claimed in claim 10, **characterized in that** one of the two resonators has a much higher oscillation frequency than the other, and said means for generating a temperature-stable signal further include a frequency divider circuit (400) for reducing the highest frequency before said difference in the oscillation frequencies is taken.

**Patentansprüche**

1. Resonatorenverbund, der in einem Einkristall (1) integriert und dazu bestimmt ist, die Umsetzung einer temperaturstabilen Zeitbasis zu ermöglichen, **dadurch gekennzeichnet, dass** er mindestens einen ersten (2) und einen zweiten (3) Resonator umfasst, die dazu vorgesehen sind, nach verschiedenartigen Modi zu schwingen und so bemessen sind, dass mindestens der erste Temperaturkoeffizient der Differenz ihrer Frequenz, $\alpha$, gleich oder nahezu Null ist.

2. Resonatorenverbund nach Anspruch 1, **dadurch gekennzeichnet, dass** der besagte Einkristall Silizium ist.

3. Resonatorenverbund nach Anspruch 1 oder Anspruch 2, **dadurch gekennzeichnet, dass** der besagte erste und der besagte zweite Resonator nach einem solchen Winkel ausgerichtet sind, dass der zweite Temperaturkoeffizient der besagten Frequenzdifferenz, $\beta$, gleich oder nahezu Null ist.

4. Resonatorenverbund nach einem der Ansprüche 1 bis 3, **dadurch gekennzeichnet, dass** der besagte erste Resonator (2) dazu vorgesehen ist, nach einem Dehnungsmodus zu schwingen.

5. Resonatorenverbund nach einem der Ansprüche 1 bis 4, **dadurch gekennzeichnet, dass** der besagte zweite Resonator (3) dazu vorgesehen ist, nach einem Lamé-Modus zu schwingen.

6. Resonatorenverbund nach irgendeinem der vorstehenden Ansprüche, **dadurch gekennzeichnet, dass** der besagte erste und der besagte zweite Resonator jeweils eine symmetrische Struktur aufweisen, die aus einem zentralen Arm (23, 33) besteht, der jeweils zwei rechteckige Platten (21, 22 und 31, 32) miteinander verbindet, wobei die besagten Resonatoren auf Höhe des Mittelteils (24, 34) der besagten zentralen Arme gehalten werden können.

7. Resonatorenverbund nach irgendeinem der vorstehenden Ansprüche, **dadurch gekennzeichnet, dass** die besagten Resonatoren piezoelektrische Erregungsmittel umfassen.

8. Resonatorenverbund nach Anspruch 7, **dadurch gekennzeichnet, dass** die besagten piezoelektrischen Erregungsmittel eine auf den besagten zentralen Armen abgelagerte AIN-Schicht (40) umfassen, sowie Elektroden (43, 45) mit denen eine Kontaktierung der besagten AIN-Schicht einerseits, und des Siliziumsubstrats andererseits ermöglicht wird.

9. Resonatorenverbund nach Anspruch 8, **dadurch gekennzeichnet, dass** das Siliziumsubstrat dotiert ist und eine der Elektroden der besagten piezoelektrischen Erregungsmittel verkörpert.

10. Temperaturkompensierte Zeitbasis, **dadurch gekennzeichnet, dass** sie einen Resonatorenverbund nach irgendeinem der vorstehenden Ansprüche, Erregungsmittel zum Anregen und Unterhalten der Resonatorenschwingungen (200, 300) und Mittel (400, 500) zur Erzeugung eines temperaturstabilen, die Differenz der Schwingungsfrequenzen der besagten Resonatoren darstellenden Signals umfasst.

11. Zeitbasis nach Anspruch 10, **dadurch gekennzeichnet, dass** einer der beiden Resonatoren eine viel höhere Schwingungsfrequenz als der andere aufweist und die besagten Mittel zur Erzeugung eines temperaturstabilen Signals ferner einen Frequenzteiler-Schaltkreis (400) zur Reduzierung der höheren Frequenz vorgängig der Ermittlung der besagten Differenz der Schwingungsfrequenzen umfassen.

Fig. 1

Fig. 2.a                         Fig. 2.b

Fig. 3

Fig. 4

Fig. 5